# EUROPÄISCHE PATENTANMELDUNG

(11) **EP 3 723 221 A1**
(43) Veröffentlichungstag der Anmeldung: **14.10.2020**
(21) Anmeldenummer: 19167797.0
(22) Anmeldetag: 08.04.2019
(51) Int. Cl.: H02H 3/04, H02H 3/16, H02H 7/26, H02H 11/00, G01R 31/02

(54) **ERKENNEN EINES ERDSCHLUSSES IN EINEM GLEICHSTROMNETZ**

(71) Anmelder: Siemens Aktiengesellschaft, 80333 München (DE)
(72) Erfinder: Schierling, Hubert, 91052 Erlangen (DE); Weis, Benno, 91334 Hemhofen (DE)

(57) **Zusammenfassung**

Die Erfindung betrifft ein Verfahren zum Erkennen eines Erdschlusses in einer einem Gleichstromnetz (1) zuschaltbaren Lastzone (3) mit einer ersten Lastzonenleitung (31), die mit einer ersten Hauptleitung (7) des Gleichstromnetzes (1) über einen Schutzschalter (45) verbindbar ist, und mit einer zweiten Lastzonenleitung (32), die mit einer zweiten Hauptleitung (9) des Gleichstromnetzes (1) über einen Unterbrechungsschalter (51) verbindbar ist. Bei dem Verfahren wird fortlaufend wenigstens eine an einer Lastzonenleitung (31, 32) anliegende Leitungsspannung gemessen. Im Falle, dass vor dem Zuschalten der Lastzone (3) an keiner Hauptleitung (7, 9) des Gleichstromnetzes (1) ein Erdschluss detektiert wird, wird bei geöffnetem Schutzschalter (45) der Unterbrechungsschalter (51) geschlossen und es wird auf einen Erdschluss in der Lastzone (3) geschlossen, wenn sich nach dem Schließen des Unterbrechungsschalters (51) wenigstens eine Leitungsspannung nicht signifikant ändert.

## Beschreibung

Die Erfindung betrifft ein Verfahren zum Erkennen eines Erdschlusses in einer einem Gleichstromnetz zuschaltbaren Lastzone und eine Zuschalteinheit zum Zuschalten einer Lastzone zu einem Gleichstromnetz.

Ein gegenüber einem Erdpotential isoliertes oder über eine hohe Impedanz geerdetes Gleichstromnetz kann bei einem Erdschluss eines Gleichspannungspotentials weiter betrieben werden. Der Erdschluss selbst kann während des Betriebs durch die Messung und Auswertung der Spannungen zwischen den Gleichspannungspotentialen des Gleichstromnetzes und einem Erdpotential leicht detektiert werden. Allerdings ist es schwierig, eine von dem Gleichstromnetz versorgte Lastzone zu identifizieren, in der der Erdschluss auftritt. Die Identifizierung derjenigen Lastzone, in der ein Erdschluss auftritt, ist jedoch wichtig, um den Erdschluss zu beseitigen. Um die fehlerhafte Lastzone zu identifizieren, könnte beispielsweise an einer Verbindungsstelle jeder Lastzone mit dem Gleichstromnetz, beispielsweise am Eingang eines Schaltschranks, ein so genannter Common-Mode-Strom, das heißt ein Fehlerstrom, der die Summe der Ströme in den beiden Anschlussleitungen der Lastzone zu den Hauptleitungen des Gleichstromnetzes ist, gemessen werden. Wenn einer der Common-Mode-Ströme von Null verschieden ist, weist dies darauf hin, dass der Erdschluss in der zugehörigen Lastzone aufgetreten ist. Die Messungen der Common-Mode-Ströme könnten beispielsweise permanent oder manuell durch Wartungspersonal durchgeführt werden. Jedoch sind derartige Messungen in jedem Fall aufwändig.

Der Erfindung liegt die Aufgabe zugrunde, ein verbessertes Verfahren zum Erkennen eines Erdschlusses in einer einem Gleichstromnetz zuschaltbaren Lastzone anzugeben.

Die Aufgabe wird erfindungsgemäß durch ein Verfahren mit den Merkmalen des Anspruchs 1 und eine Zuschalteinheit mit den Merkmalen des Anspruchs 10 gelöst.

Vorteilhafte Ausgestaltungen der Erfindung sind Gegenstand der abhängigen Ansprüche.

Das erfindungsgemäßen Verfahren dient dem Erkennen eines Erdschlusses in einer einem Gleichstromnetz zuschaltbaren Lastzone mit einer ersten Lastzonenleitung, die über eine Parallelschaltung eines ersten Erdungskondensators und eines ersten Erdungswiderstands geerdet ist und mit einer ersten Hauptleitung des Gleichstromnetzes über einen Schutzschalter verbindbar ist, und mit einer zweiten Lastzonenleitung, die über eine Parallelschaltung eines zweiten Erdungskondensators und eines zweiten Erdungswiderstands geerdet ist und mit einer zweiten Hauptleitung des Gleichstromnetzes über einen Unterbrechungsschalter verbindbar ist. Bei dem Verfahren wird fortlaufend wenigstens eine einer Lastzonenleitung zugeordnete Leitungsspannung zwischen einem Leitungspotential, auf dem die Lastzonenleitung liegt, und einem Erdpotential gemessen. Im Falle, dass vor dem Zuschalten der Lastzone an keiner Hauptleitung des Gleichstromnetzes ein Erdschluss detektiert wird, wird der Unterbrechungsschalter bei geöffnetem Schutzschalter geschlossen und es wird auf einen Erdschluss in der Lastzone geschlossen, wenn sich nach dem Schließen des Unterbrechungsschalters wenigstens eine Leitungsspannung nicht signifikant ändert. Es wird hier und im Folgenden stets angenommen, dass das Gleichstromnetz gegenüber einem Erdpotential isoliert oder über eine hohe Impedanz geerdet ist.

Das Verfahren nutzt aus, dass vor dem Schließen des Unterbrechungsschalters beide Erdungskondensatoren entladen sind und somit beide Leitungsspannungen Null sind und daher nach dem Schließen des Unterbrechungsschalters Null oder auf einem kleinen Wert bleiben, wenn an einer der Lastzonenleitungen ein Erdschluss vorliegt. Daher kann ein Erdschluss in der Lastzone dadurch erkannt werden, dass sich wenigstens eine Leitungsspannung nach dem Schließen des Unterbrechungsschalters nicht oder nur wenig ändert. Das Verfahren ermöglicht somit insbesondere vorteilhaft eine Erkennung eines Erdschlusses in einer Lastzone, noch bevor die Lastzone dem Gleichstromnetz über den Schutzschalter zugeschaltet ist.

Eine Ausgestaltung des Verfahrens sieht vor, dass fortlaufend für beide Lastzonenleitungen jeweils die zugeordnete Leitungsspannung gemessen und ausgewertet wird. Dies ermöglicht vorteilhaft eine zuverlässigere Erkennung eines Erdschlusses in der Lastzone als die Messung und Auswertung nur einer Leitungsspannung.

Ferner kann vorgesehen sein, dass eine erste Verzögerungsdauer und eine absolute oder relative erste Mindeständerung vorgegeben werden und eine Änderung einer Leitungsspannung nach dem Schließen des Unterbrechungsschalters als signifikant eingestuft wird, wenn die Änderung nach Ablauf der ersten Verzögerungsdauer nach dem Schließen des Unterbrechungsschalters die erste Mindeständerung übertrifft.

Durch die Vorgabe der ersten Mindeständerung für eine Leitungsspannung kann quantifiziert werden, wann eine Änderung einer Leitungsspannung nach dem Schließen des Unterbrechungsschalters als signifikant angesehen wird. Dadurch können Fehlentscheidungen aufgrund von Änderungen der Leitungsspannung, die trotz Erdschluss entstehen, vorteilhaft reduziert oder ganz vermieden werden. Die Vorgabe der ersten Verzögerungsdauer für die Auswertung der Änderung einer Leitungsspannung ermöglicht vorteilhaft, Fehlerkennungen von Erdschlüssen aufgrund von Einschwingvorgängen nach dem Schließen des Unterbrechungsschalters vorteilhaft zu reduzieren oder ganz zu vermeiden. Die erste Verzögerungsdauer wird beispielsweise im Bereich von 0,1 ms bis 100 ms vorgegeben wird. Insbesondere kann etwa 1 ms als erste Verzögerungsdauer vorgegeben werden. Die erste Mindeständerung wird beispielsweise im Bereich von 5 % bis 50 % einer Nennspannung des Gleichstromnetzes vorgegeben. Insbesondere kann sie etwa 16 % der Nennspannung betragen.

Eine weitere Ausgestaltung des Verfahrens sieht vor, dass die erste Lastzonenleitung außer über den Schutzschalter über eine parallel zu dem Schutzschalter geschaltete Reihenschaltung eines Vorladeschalters und eines Vorladewiderstands mit der ersten Hauptleitung verbindbar ist, und dass im Falle, dass vor dem Zuschalten der Lastzone an der zweiten Hauptleitung des Gleichstromnetzes ein Erdschluss detektiert wird, bei geöffnetem Schutzschalter und geöffnetem Unterbrechungsschalter der Vorladeschalter geschlossen wird und auf einen Erdschluss in der Lastzone geschlossen wird, wenn sich nach dem Schließen des Vorladeschalters wenigstens eine Leitungsspannung nicht signifikant ändert. Wenn die beiden Lastzonenleitungen durch einen Speicherkondensator miteinander verbunden sind und ein Ladezustand des Speicherkondensators erfasst wird, kann ferner auf einen Erdschluss an der ersten Lastzonenleitung geschlossen werden, wenn sich nach dem Schließen des Vorladeschalters der Speicherkondensator nicht signifikant auflädt, und/oder auf einen Erdschluss an der zweiten Lastzonenleitung kann geschlossen werden, wenn sich nach dem Schließen des Vorladeschalters der Speicherkondensator signifikant auflädt.

Die vorgenannten Ausgestaltungen des Verfahrens nutzen aus, dass im Falle eines Erdschlusses an der zweiten Hauptleitung nach dem Schließen des Vorladeschalters die einer Lastzonenleitung zugeordnete Leitungsspannung Null oder auf einem kleinen Wert bleibt, wenn ein Erdschluss an dieser Lastzonenleitung vorliegt. Der Vorladewiderstand verhindert dabei, dass durch das Schließen des Vorladeschalters sofort ein Kurzschluss in dem Gleichstromnetz erzeugt wird. Wenn vor dem Zuschalten der Lastzone hingegen ein Erdschluss an der ersten Hauptleitung vorliegt, ist die Erdschlusserkennung in der Lastzone nicht auf entsprechende Weise möglich, weil durch Schließen des Vorladeschalters keine Potentialänderung in der Lastzone hervorgerufen wird und das Schließen des Unterbrechungsschalters sofort einen Kurzschluss in dem Gleichstromnetz erzeugt.

Ferner kann vorgesehen sein, dass eine zweite Verzögerungsdauer und eine absolute oder relative zweite Mindeständerung vorgegeben werden und eine Änderung einer Leitungsspannung nach dem Schließen des Vorladeschalters als signifikant eingestuft wird, wenn die Änderung nach Ablauf der zweiten Verzögerungsdauer nach dem Schließen des Vorladeschalters die zweite Mindeständerung übertrifft. Die zweite Verzögerungsdauer kann dabei mit der ersten Verzögerungsdauer übereinstimmen und die zweite Mindeständerung kann mit der ersten Mindeständerung übereinstimmen. Eine Aufladung des Speicherkondensators wird beispielsweise als signifikant eingestuft, wenn sich der Speicherkondensator innerhalb einer vorgegebenen Messdauer um eine vorgegebene Mindestaufladung auflädt. Beispielsweise werden eine Messdauer im Bereich von 100 ms bis 5 s, insbesondere eine Messdauer von etwa 1 s, und eine Mindestaufladung im Bereich von 10 % bis 50 % der Nennspannung des Gleichstromnetzes, insbesondere eine Mindestaufladung von etwa 20 % der Nennspannung, vorgegeben.

Eine erfindungsgemäße Zuschalteinheit zum Zuschalten einer Lastzone zu einem Gleichstromnetz, das zwei Hauptleitungen und eine Erdschlussüberwachungseinheit, die dazu eingerichtet ist, für jede Hauptleitung einen Erdschluss an der Hauptleitung zu detektieren, aufweist, umfasst:
- einen zwischen die erste Hauptleitung und eine erste Lastzonenleitung der Lastzone geschalteten Schutzschalter,
- einen zwischen die zweite Hauptleitung und eine zweite Lastzonenleitung der Lastzone geschalteten Unterbrechungsschalter,
- für wenigstens eine Lastzonenleitung eine Messeinheit, die dazu eingerichtet ist, fortlaufend eine der Lastzonenleitung zugeordnete Leitungsspannung zwischen einem Leitungspotential, auf dem die Lastzonenleitung liegt, und einem Erdpotential zu messen, und
- eine Steuereinheit, die dazu eingerichtet ist, den Schutzschalter anzusteuern und den Schaltzustand des Unterbrechungsschalters zu erkennen, die Messsignale der wenigstens einen Messeinheit und der Erdschlussüberwachungseinheit zu empfangen und im Falle, dass vor dem Zuschalten der Lastzone an keiner Hauptleitung des Gleichstromnetzes ein Erdschluss detektiert wird, auf einen Erdschluss in der Lastzone zu schließen, wenn sich nach dem Schließen des Unterbrechungsschalters bei geöffnetem Schutzschalter wenigstens eine Leitungsspannung nicht signifikant ändert.

Darüber hinaus kann die Zuschalteinheit eine parallel zu dem Schutzschalter geschaltete Reihenschaltung eines Vorladeschalters und eines Vorladewiderstands aufweisen, und die Steuereinheit kann dazu eingerichtet sein, den Schaltzustand des Vorladeschalters zu erkennen und im Falle, dass vor dem Zuschalten der Lastzone an der zweiten Hauptleitung des Gleichstromnetzes ein Erdschluss detektiert wird, auf einen Erdschluss in der Lastzone zu schließen, wenn sich nach dem Schließen des Vorladeschalters bei geöffnetem Schutzschalter und geöffnetem Unterbrechungsschalter eine Leitungsspannung nicht signifikant ändert.

Eine erfindungsgemäße Zuschalteinheit ermöglicht die Durchführung des erfindungsgemäßen Verfahrens mit den oben bereits genannten Vorteilen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 ein Blockschaltbild eines Gleichstromnetzes, dem mehrere Lastzonen zuschaltbar sind,
FIG 2 ein Blockschaltbild einer Lastzone,
FIG 3 ein Blockschaltbild einer Zuschalteinheit, mit der dem Gleichstromnetz eine Lastzone zuschaltbar ist.

Einander entsprechende Teile sind in den Figuren mit denselben Bezugszeichen versehen.

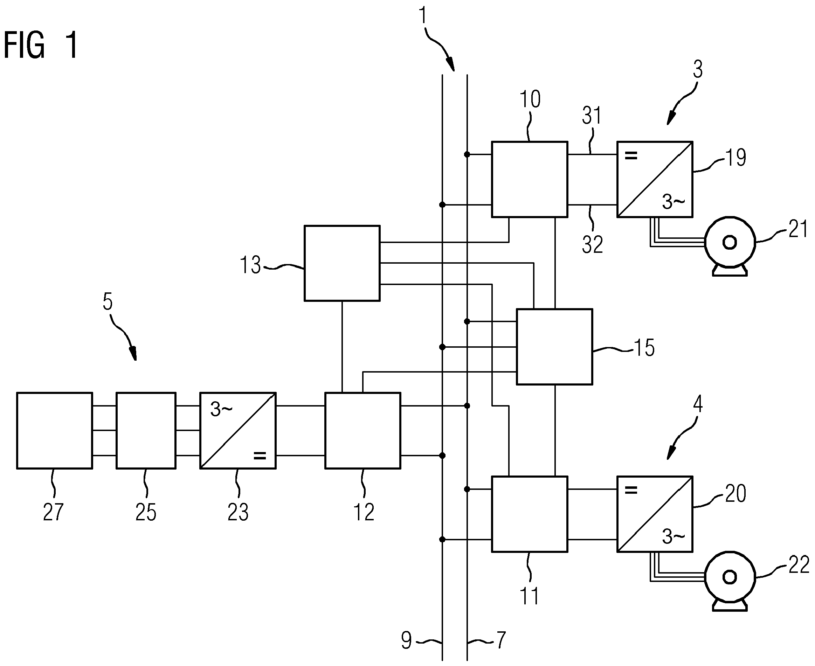

Figur 1 zeigt schematisch ein Gleichstromnetz 1, dem mehrere Lastzonen 3, 4, 5 zuschaltbar sind. Das Gleichstromnetz 1 ist gegenüber einem Erdpotential isoliert oder über eine hohe Impedanz geerdet.

Das Gleichstromnetz 1 weist zwei elektrische Hauptleitungen 7, 9, für jede Lastzone 3, 4, 5 eine Zuschalteinheit 10, 11, 12 sowie eine Netzsteuereinheit 13 und eine Erdschlussüberwachungseinheit 15 auf.

In der Figur sind beispielhaft drei Lastzonen 3, 4, 5 dargestellt. Eine erste Lastzone 3 und eine zweite Lastzone 4 weisen jeweils einen Stromrichter 19, 20 und eine elektrische Maschine 21, 22 auf. Eine dritte Lastzone 5 weist einen Stromrichter 23, eine Schalt- und Schutzeinheit 25 für Wechselstrom und ein Wechselstromnetz 27 auf, wobei die Schalt- und Schutzeinheit 25 zwischen das Wechselstromnetz 27 und den Stromrichter 23 geschaltet ist. Jeder Stromrichter 19, 20, 23 ist mit einer Zuschalteinheit 10, 11, 12 verbunden.

Eine erste Hauptleitung 7 liegt auf einem ersten Gleichspannungspotential des Gleichstromnetzes 1. Die zweite Hauptleitung 9 liegt auf einem zweiten Gleichspannungspotential des Gleichstromnetzes 1.

Jede Zuschalteinheit 10, 11, 12 ist einer Lastzone 3, 4, 5 zugeordnet, die dem Gleichstromnetz 1 durch die Zuschaltschalteinheit 10, 11, 12 zuschaltbar ist.

Die Netzsteuereinheit 13 ist mit den Zuschalteinheiten 10, 11, 12 und der Erdschlussüberwachungseinheit 15 verbunden. Von der Netzsteuereinheit 13 wird das Zuschalten der Lastzonen 3, 4, 5 gesteuert.

Die Erdschlussüberwachungseinheit 15 ist dazu eingerichtet, Erdschlüsse an den Hauptleitungen 7, 9 zu detektieren. Dazu ist die Erdschlussüberwachungseinheit 15 mit jeder Hauptleitung 7, 9 verbunden und dazu eingerichtet, die Spannungen zwischen dem Erdpotential und den Gleichspannungspotentialen, auf denen die Hauptleitungen 7, 9 liegen, zu messen. Ferner ist die Erdschlussüberwachungseinheit 15 dazu eingerichtet, den Zuschalteinheiten 10, 11, 12 und der Netzsteuereinheit 13 einen detektierten Erdschluss zu melden.

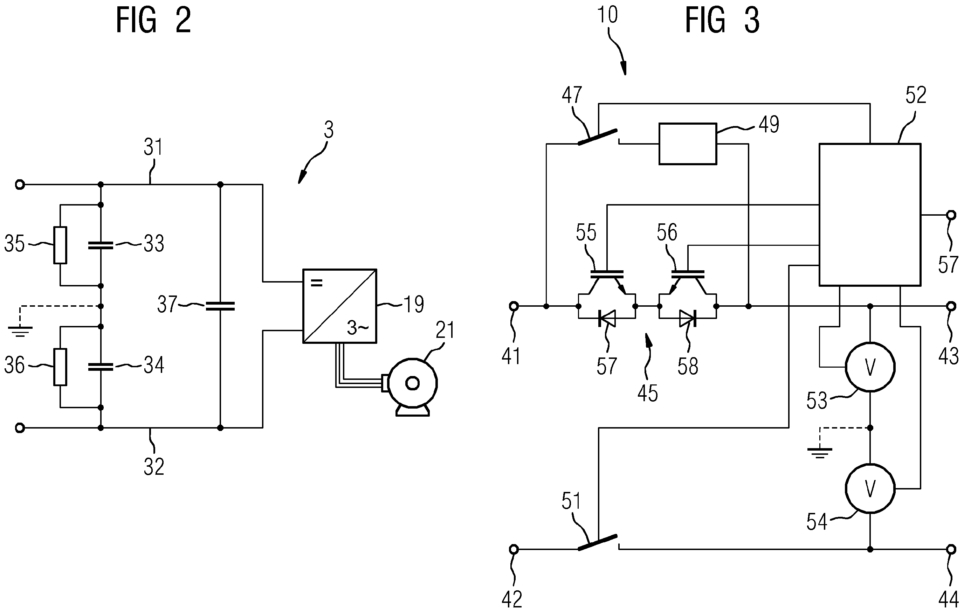

Figur 2 zeigt beispielhaft ein Blockschaltbild der Lastzone 3. Die Lastzone 3 weist eine erste Lastzonenleitung 31 auf, die über eine Parallelschaltung eines ersten Erdungskondensators 33 und eines ersten Erdungswiderstands 35 hochimpedant ohmsch-kapazitiv geerdet ist. Ferner weist die Lastzone 3 eine zweite Lastzonenleitung 32 auf, die über eine Parallelschaltung eines zweiten Erdungskondensators 34 und eines zweiten Erdungswiderstands 36 hochimpedant ohmsch-kapazitiv geerdet ist. Die Erdungskondensatoren 33, 34 weisen gleiche Kapazitäten auf, um die Leitungspotentiale, auf denen die Lastzonenleitungen 31, 32 liegen, im fehlerfreien Betrieb symmetrisch zu dem Erdpotential zu halten. Die Lastzonenleitungen 31, 32 sind ferner durch einen Speicherkondensator 37 miteinander verbunden.

Figur 3 zeigt ein Blockschaltbild der Zuschalteinheit 10, die der Lastzone 3 zugeordnet ist. Die Zuschalteinheit 10 weist zwei netzseitige Anschlüsse 41, 42, zwei lastzonenseitige Anschlüsse 43, 44, einen Schutzschalter 45, einen Vorladeschalter 47, einen Vorladewiderstand 49, einen Unterbrechungsschalter 51, eine Steuereinheit 52 und zwei Messeinheiten 53, 54 auf.

Ein erster netzseitiger Anschluss 41 wird mit der ersten Hauptleitung 7 verbunden. Der zweite Anschluss 42 wird mit der zweiten Hauptleitung 9 verbunden. Ein erster lastzonenseitiger Anschluss 43 wird mit der ersten Lastzonenleitung 31 verbunden. Der zweite lastzonenseitige Anschluss 44 wird mit der zweiten Lastzonenleitung 32 verbunden.

Der Schutzschalter 45 ist zwischen den ersten netzseitigen Anschluss 41 und den ersten lastzonenseitigen Anschluss 43 geschaltet. Der Schutzschalter 45 weist zwei abschaltbare Halbleiterschalter 55, 56 und zwei Dioden 57, 58 auf. Die Halbleiterschalter 55, 56 sind antiseriell geschaltet, das heißt die Halbleiterschalter 55, 56 sind in Reihe, aber mit einander entgegensetzten Durchlassrichtungen geschaltet. Jede Diode 57, 58 ist antiparallel zu einem der Halbleiterschalter 55, 56 geschaltet. Der Schutzschalter 45 ist als ein schneller Schalter ausgebildet, der Kurzschlussströme abschalten kann.

Der Vorladeschalter 47 und der Vorladewiderstand 49 sind in Reihe geschaltet, wobei die Reihenschaltung des Vorladeschalters 47 und des Vorladewiderstands 49 parallel zu dem Schutzschalter 45 zwischen den ersten netzseitigen Anschluss 41 und den ersten lastzonenseitigen Anschluss 43 geschaltet ist. Der Vorladeschalter 47 ist beispielsweise ein mechanischer Schalter.

Der Unterbrechungsschalter 51 ist zwischen den zweiten netzseitigen Anschluss 42 und den zweiten lastzonenseitigen Anschluss 44 geschaltet. Der Unterbrechungsschalter 51 ist beispielsweise ein mechanischer Lasttrennschalter.

Eine erste Messeinheit 53 ist dazu eingerichtet, fortlaufend eine der ersten Lastzonenleitung 31 zugeordnete erste Leitungsspannung zwischen einem Leitungspotential, auf dem die erste Lastzonenleitung 31 liegt, und dem Erdpotential zu messen. Die zweite Messeinheit 54 ist dazu eingerichtet, fortlaufend eine der zweiten Lastzonenleitung 32 zugeordnete zweite Leitungsspannung zwischen einem Leitungspotential, auf dem die zweite Lastzonenleitung 32 liegt, und dem Erdpotential zu messen. Die Messeinheiten 53, 54 übertragen die von ihnen erfassten Messsignale zu der Steuereinheit 52.

Die Steuereinheit 52 ist dazu eingerichtet, den Schutzschalter 45 beziehungsweise dessen Halbleiterschalter 55, 56 anzusteuern und die Schaltzustände des Vorladeschalters 47 und des Unterbrechungsschalters 51 zu erkennen. Ferner weist die Steuereinheit 52 eine Schnittstelle 57 auf, über die sie mit der Netzsteuereinheit 13 und der Erdschlussüberwachungseinheit 15 verbunden ist und über die ihr Steuersignale der Netzsteuereinheit 13 übermittelt und von der Erdschlussüberwachungseinheit 15 detektierte Erdschlüsse gemeldet werden.

Wenn die Lastzone 3 von dem Gleichstromnetz 1 getrennt ist, sind der Schutzschalter 45 (beziehungsweise beide Halbleiterschalter 55, 56), der Vorladeschalter 47 und der Unterbrechungsschalter 51 geöffnet. Wenn kein Erdschluss vorliegt, wird zum Zuschalten der Lastzone 3 zunächst der Unterbrechungsschalter 51, danach der Vorladeschalter 47 und schließlich, nach Abschluss der Vorladung der Kondensatoren 33, 34, 37, der Schutzschalter 45 geschlossen.

Erfindungsgemäß werden im Falle, dass vor dem Zuschalten der Lastzone 3 an keiner Hauptleitung 7, 9 des Gleichstromnetzes ein Erdschluss detektiert wird, nach dem Schließen des Unterbrechungsschalters 51, aber vor dem Schließen des Vorladeschalters 47 und des Schutzschalters 45 von der Steuereinheit 52 die Leitungsspannungen ausgewertet, wobei geprüft wird, ob sich die Leitungsspannungen nach dem Schließen des Unterbrechungsschalters 51 signifikant ändern. Wenn sich wenigstens eine Leitungsspannung nicht signifikant ändert, wird auf einen Erdschluss in der Lastzone 3 geschlossen. Dazu werden beispielsweise für jede Leitungsspannung eine erste Verzögerungsdauer und eine absolute oder relative erste Mindeständerung vorgegeben und eine Änderung der Leitungsspannung nach dem Schließen des Unterbrechungsschalters 51 wird als signifikant eingestuft, wenn die Änderung nach Ablauf der ersten Verzögerungsdauer nach dem Schließen des Unterbrechungsschalters 51 die erste Mindeständerung übertrifft.

Im Falle, dass vor dem Zuschalten der Lastzone 3 an der zweiten Hauptleitung 9 des Gleichstromnetzes 1 ein Erdschluss detektiert wird, wird nicht der Unterbrechungsschalter 51, sondern der Vorladeschalter 47 zuerst geschlossen und die Leitungsspannungen werden ausgewertet, bevor der Unterbrechungsschalter 51 und der Schutzschalter 45 geschlossen werden. Auf einen Erdschluss in der Lastzone 3 wird geschlossen, wenn sich nach dem Schließen des Vorladeschalters 47 eine Leitungsspannung nicht signifikant ändert. Dazu werden beispielsweise für jede Leitungsspannung eine zweite Verzögerungsdauer und eine absolute oder relative zweite Mindeständerung vorgegeben und eine Änderung der Leitungsspannung nach dem Schließen des Vorladeschalters 47 wird als signifikant eingestuft, wenn die Änderung nach Ablauf der zweiten Verzögerungsdauer nach dem Schließen des Vorladeschalters 47 die zweite Mindeständerung übertrifft. Der Vorladewiderstand 49 verhindert in diesem Fall, dass ein Schließen des Vorladeschalters 47 sofort einen Kurzschluss in dem Gleichstromnetz 1 erzeugt. Ferner kann ein Ladezustand des Speicherkondensators 37 erfasst werden, und es kann auf einen Erdschluss an der ersten Lastzonenleitung 31 geschlossen werden, wenn sich nach dem Schließen des Vorladeschalters 47 der Speicherkondensator 37 nicht signifikant auflädt, und auf einen Erdschluss an der zweiten Lastzonenleitung 32 kann geschlossen werden, wenn sich nach dem Schließen des Vorladeschalters 47 der Speicherkondensator 37 signifikant auflädt.

Wenn vor dem Zuschalten der Lastzone 3 ein Erdschluss an der ersten Hauptleitung 7 vorliegt, ist die Erdschlusserkennung in der Lastzone 3 in entsprechender Weise nicht möglich, weil durch Schließen des Vorladeschalters 47 keine Potenzialänderung in der Lastzone 3 hervorgerufen wird und das Schließen des Unterbrechungsschalters 51 sofort einen Kurzschluss in dem Gleichstromnetz 1 erzeugen würde, wenn bereits ein Erdschluss an der Lastzonenleitung 32 vorliegt.

Ein von der Steuereinheit 52 erkannter Erdschluss in der Lastzone 3 wird der Netzsteuereinheit 13 über die Schnittstelle 57 von der Steuereinheit 52 gemeldet.

Die anhand der Figuren beschriebenen Ausführungsbeispiele des erfindungsgemäßen Verfahrens und einer erfindungsgemäßen Zuschalteinheit 10 können auf verschiedene Weisen zu weiteren Ausführungsbeispielen abgewandelt werden. Beispielsweise kann vorgesehen sein, dass die von den Messeinheiten 53, 54 erfassten Leitungsspannungen nicht lokal von der Steuereinheit 52 der Zuschalteinheit 10 sondern von der Netzsteuereinheit 13 ausgewertet werden.

Alternativ oder zusätzlich kann vorgesehen sein, dass nur die erste oder nur die zweite Leitungsspannung gemessen und ausgewertet wird.

Beispielsweise kann vorgesehen sein, dass nur die erste Leitungsspannung gemessen und ausgewertet wird. Im Falle, dass vor dem Zuschalten der Lastzone 3 an keiner Hauptleitung 7, 9 des Gleichstromnetzes ein Erdschluss detektiert wird, wird dann wiederum zunächst der Unterbrechungsschalter 51 geschlossen und die erste Leitungsspannung wird vor dem Schließen des Vorladeschalters 47 und des Schutzschalters 45 ausgewertet. Wenn sich die erste Leitungsspannung nach dem Schließen des Unterbrechungsschalters 51 nicht signifikant ändert, wird auf einen Erdschluss in der Lastzone 3 geschlossen. Im Falle, dass vor dem Zuschalten der Lastzone 3 an der zweiten Hauptleitung 9 des Gleichstromnetzes 1 ein Erdschluss detektiert wird, wird der Vorladeschalter 47 zuerst geschlossen und die Leitungsspannungen werden ausgewertet, bevor der Unterbrechungsschalter 51 und der Schutzschalter 45 geschlossen werden. Auf einen Erdschluss in der Lastzone 3 wird geschlossen, wenn sich nach dem Schließen des Vorladeschalters 47 die erste Leitungsspannung nicht signifikant ändert.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Erkennen eines Erdschlusses in einer einem Gleichstromnetz (1) zuschaltbaren Lastzone (3) mit einer ersten Lastzonenleitung (31), die über eine Parallelschaltung eines ersten Erdungskondensators (33) und eines ersten Erdungswiderstands (35) geerdet ist und mit einer ersten Hauptleitung (7) des Gleichstromnetzes (1) über einen Schutzschalter (45) verbindbar ist, und mit einer zweiten Lastzonenleitung (32), die über eine Parallelschaltung eines zweiten Erdungskondensators (34) und eines zweiten Erdungswiderstands (36) geerdet ist und mit einer zweiten Hauptleitung (9) des Gleichstromnetzes (1) über einen Unterbrechungsschalter (51) verbindbar ist, wobei
- fortlaufend wenigstens eine einer Lastzonenleitung (31, 32) zugeordnete Leitungsspannung zwischen einem Leitungspotential, auf dem die Lastzonenleitung (31, 32) liegt, und einem Erdpotential gemessen wird, und
- im Falle, dass vor dem Zuschalten der Lastzone (3) an keiner Hauptleitung (7, 9) des Gleichstromnetzes (1) ein Erdschluss detektiert wird, bei geöffnetem Schutzschalter (45) der Unterbrechungsschalter (51) geschlossen wird
- und auf einen Erdschluss in der Lastzone (3) geschlossen wird, wenn sich nach dem Schließen des Unterbrechungsschalters (51) wenigstens eine Leitungsspannung nicht signifikant ändert.

2. Verfahren nach Anspruch 1, wobei fortlaufend für beide Lastzonenleitungen (31, 32) jeweils die zugeordnete Leitungsspannung gemessen und ausgewertet wird.

3. Verfahren nach einem der vorhergehenden Ansprüche, wobei eine erste Verzögerungsdauer und eine absolute oder relative erste Mindeständerung vorgegeben werden und eine Änderung einer Leitungsspannung nach dem Schließen des Unterbrechungsschalters (51) als signifikant eingestuft wird, wenn die Änderung nach Ablauf der ersten Verzögerungsdauer nach dem Schließen des Unterbrechungsschalters (51) die erste Mindeständerung übertrifft.

4. Verfahren nach Anspruch 3, wobei die erste Verzögerungsdauer im Bereich von 0,1 ms bis 100 ms vorgegeben wird.

5. Verfahren nach Anspruch 3 oder 4, wobei die erste Mindeständerung im Bereich von 5 % bis 50 % einer Nennspannung des Gleichstromnetzes (1) vorgegeben wird.

6. Verfahren nach einem der vorhergehenden Ansprüche, wobei die erste Lastzonenleitung (31) außer über den Schutzschalter (45) über eine parallel zu dem Schutzschalter (45) geschaltete Reihenschaltung eines Vorladeschalters (47) und eines Vorladewiderstands (49) mit der ersten Hauptleitung (7) verbindbar ist, und wobei im Falle, dass vor dem Zuschalten der Lastzone (3) an der zweiten Hauptleitung (9) des Gleichstromnetzes (1) ein Erdschluss detektiert wird, bei geöffnetem Schutzschalter (45) und geöffnetem Unterbrechungsschalter (51) der Vorladeschalter (47) geschlossen wird und auf einen Erdschluss in der Lastzone (3) geschlossen wird, wenn sich nach dem Schließen des Vorladeschalters (47) wenigstens eine Leitungsspannung nicht signifikant ändert.

7. Verfahren nach Anspruch 6, wobei die beiden Lastzonenleitungen (31, 32) durch einen Speicherkondensator (37) miteinander verbunden sind und ein Ladezustand des Speicherkondensators (37) erfasst wird, und wobei auf einen Erdschluss an der ersten Lastzonenleitung (31) geschlossen wird, wenn sich nach dem Schließen des Vorladeschalters (47) der Speicherkondensator (37) nicht signifikant auflädt.

8. Verfahren nach Anspruch 7, wobei auf einen Erdschluss an der zweiten Lastzonenleitung (32) geschlossen wird, wenn sich nach dem Schließen des Vorladeschalters (47) der Speicherkondensator (37) signifikant auflädt.

9. Verfahren nach einem der Ansprüche 6 bis 8, wobei eine zweite Verzögerungsdauer und eine absolute oder relative zweite Mindeständerung vorgegeben werden und eine Änderung einer Leitungsspannung nach dem Schließen des Vorladeschalters (47) als signifikant eingestuft wird, wenn die Änderung nach Ablauf der zweiten Verzögerungsdauer nach dem Schließen des Vorladeschalters (47) die zweite Mindeständerung übertrifft.

10. Zuschalteinheit (10) zum Zuschalten einer Lastzone (3) zu einem Gleichstromnetz (1), das zwei Hauptleitungen (7, 9) und eine Erdschlussüberwachungseinheit (15), die dazu eingerichtet ist, für jede Hauptleitung (7, 9) einen Erdschluss an der Hauptleitung (7, 9) zu detektieren, aufweist, die Zuschalteinheit (10) umfassend
- einen zwischen die erste Hauptleitung (7) und eine erste Lastzonenleitung (31) der Lastzone (3) geschalteten Schutzschalter (45),
- einen zwischen die zweite Hauptleitung (9) und eine zweite Lastzonenleitung (32) der Lastzone (3) geschalteten Unterbrechungsschalter (51),
- für wenigstens eine Lastzonenleitung (31, 32) eine Messeinheit (53, 54), die dazu eingerichtet ist, fortlaufend eine der Lastzonenleitung (31, 32) zugeordnete Leitungsspannung zwischen einem Leitungspotential, auf dem die Lastzonenleitung (31, 32) liegt, und einem Erdpotential zu messen, und
- eine Steuereinheit (52), die dazu eingerichtet ist, den Schutzschalter (45) anzusteuern und den Schaltzustand des Unterbrechungsschalters (51) zu erkennen, die Messsignale der wenigstens einen Messeinheit (53, 54) und der Erdschlussüberwachungseinheit (15) zu empfangen und im Falle, dass vor dem Zuschalten der Lastzone (3) an keiner Hauptleitung (7, 9) des Gleichstromnetzes (1) ein Erdschluss detektiert wird, auf einen Erdschluss in der Lastzone (3) zu schließen, wenn sich nach dem Schließen des Unterbrechungsschalters (51) bei geöffnetem Schutzschalter (45) wenigstens eine Leitungsspannung nicht signifikant ändert.

11. Zuschalteinheit (10) nach Anspruch 10 mit einer parallel zu dem Schutzschalter (45) geschalteten Reihenschaltung eines Vorladeschalters (47) und eines Vorladewiderstands (49), wobei die Steuereinheit (52) dazu eingerichtet ist, den Schaltzustand des Vorladeschalters (47) zu erkennen und im Falle, dass vor dem Zuschalten der Lastzone (3) an der zweiten Hauptleitung (9) des Gleichstromnetzes (1) ein Erdschluss detektiert wird, auf einen Erdschluss in der Lastzone (3) zu schließen, wenn sich nach dem Schließen des Vorladeschalters (47) bei geöffnetem Schutzschalter (45) und geöffnetem Unterbrechungsschalter (51) wenigstens eine Leitungsspannung nicht signifikant ändert.
